# EUROPEAN PATENT SPECIFICATION

(11) **EP 1 591 351 B1**
(45) Date of publication and mention of the grant of the patent: **02.05.2007**
(21) Application number: 05001919.9
(22) Date of filing: 31.01.2005
(51) Int. Cl.: B62D 65/00, G01R 31/00, B60K 37/00

(54) **Electric inspection device of cockpit module assembly for vehicle**
Elektrische Inspektionsvorrichtung eines Armaturenbrettmoduls eines Fahrzeugs
Appareil d'inspection électrique pour un module de tableau de bord d'un véhicule

(30) Priority: 28.04.2004 JP 2004134422
(43) Date of publication of application: 02.11.2005
(73) Proprietor: DENSO THERMAL SYSTEMS S.p.A., 10046 Poirino (Torino) (IT); Denso Corporation and Denso Thermal Systems Spa, Aichi-pref. 448-8661 (JP)
(72) Inventor: Mizutani, Satoshi, Kariya-city Aichi-pref. (JP)
(74) Representative: Marchitelli, Mauro

(56) References cited:
- EP-A- 0 108 522
- US-A- 6 021 366
- US-A- 6 043 661

## Description

The present invention relates to an electric inspection device of a cockpit module assembly for a vehicle in which parts to be mounted in the front of a vehicle compartment are pre-integrated into one unit.

In recent years, a cockpit module assembly in which parts to be mounted in the front of a vehicle compartment are pre-integrated into one unit is known. This whole integrated cockpit module assembly is mounted as one unit at one time in the vehicle to simplify a vehicle assembly process (for example, patent document 1).

Document EP 0 108 522 A1 discloses an instrument panel for a motor car. The instrument panel is assembled with its instruments, its own harness and a heater unit before the panel is mounted in the car. Production of the instrument panel as a sub-assembly in this way makes the final assembly into the car very much easier and also allows the function of all the instruments to be checked before the sub-assembly enters the car. The electrical connections between the wiring harness of the instrument panel and the wiring harness in the rest of the car can be made through a single connector plug.

In the assembly process of such a cockpit module assembly, in general, the cockpit module assembly is assembled and then an electric inspection for checking whether electric and electronic parts (devices) operate normally is conducted. This electric inspection is conducted in a state where an inspection connector at the end of a wire harness extending from an electric inspection device is connected to the connector of the cockpit module assembly.

However, when the connector of the cockpit module assembly is a reception connector held and fixed by the assembly so as to facilitate electric connection to the vehicle when the cockpit module assembly is mounted in the vehicle, this reception connector is arranged in the back surface, which is a surface facing the vehicle, of the cockpit module assembly vehicle.

In contrast to this, in the cockpit module assembly, function parts for performing various operations and displays are arranged mainly on the front side. Hence, an inspector conducts inspection while performing operations and display check on the front side of the cockpit module assembly. Therefore, when the inspector conducts the electric inspection, the inspector on the front side of the cockpit module assembly needs to connect the inspection connector to the reception connector on the back side, which results in poor workability.

The invention has been made in view of the above problem. The object of the invention is to provide an electric inspection device capable of improving workability in connecting a reception connector of a cockpit module assembly to an inspection connector at the time of conducting electric inspection of the cockpit module assembly of a vehicle.

The above object is achieved through the appended claims.

Hereafter, embodiments of the invention will be described with reference to the drawings.

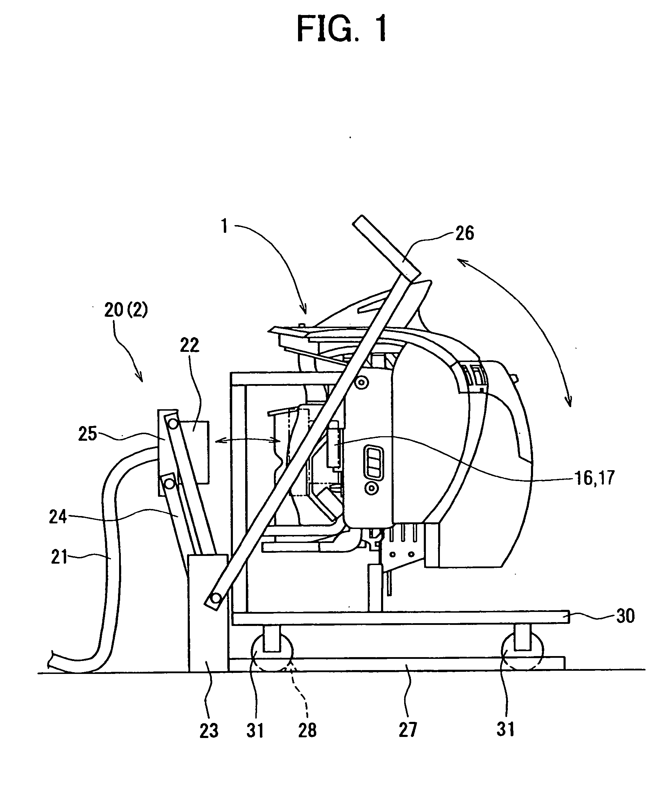

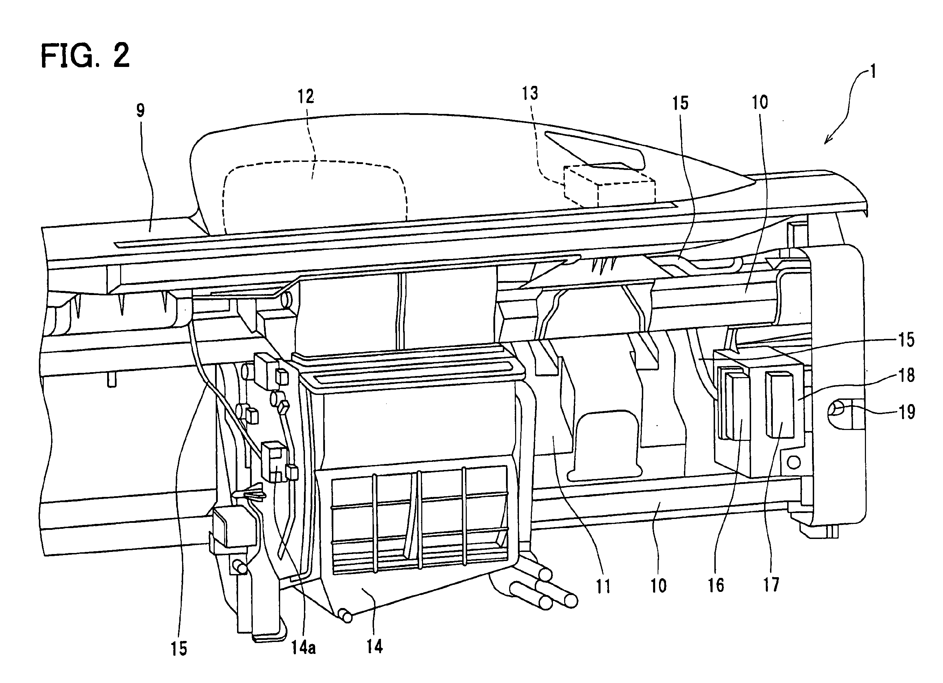

FIG. 1 is a side view showing a state where a cockpit module assembly 1 for a vehicle, which is a member to be inspected, is arranged in a connection arrangement part 20 (hereinafter referred to as cockpit module) of an electric inspection device (inspection bench) 2 in the first embodiment. FIG. 2 is a perspective view showing the back side of the cockpit module assembly 1 (side of the surface where the cockpit module assembly 1 is fixed to the vehicle), which is a member to be inspected.

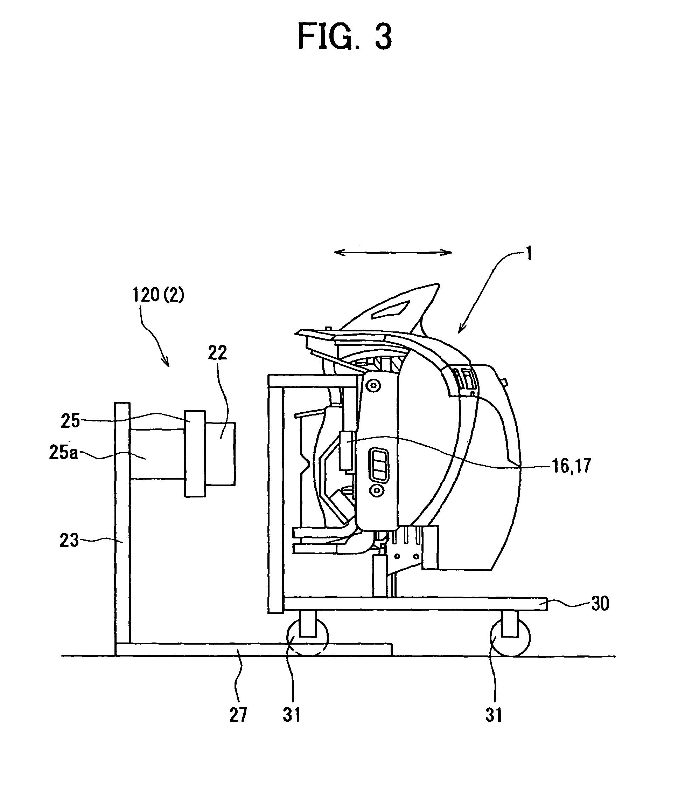

FIG. 3 is a side view showing a state where a cockpit module assembly 1 for a vehicle, which is a member to be inspected, is arranged in the connection arrangement part of an electric inspection device in the second embodiment.

As shown in FIG. 2, the cockpit module 1 is such that parts to be mounted in the front of vehicle compartment (cockpit front portion) are pre-integrated into one unit before they are mounted in the vehicle. The cockpit module 1 includes a bar-shaped member (reinforcing bar) 10 as a strengthening member extending in the lateral direction in the drawing (in the direction of width of the vehicle) and structure bracket 11. The bar-shaped member 10 and the bracket 11 construct a structural member in this embodiment.

The structural member including the bar-shaped member 10 and the bracket 11 is mounted with mounted parts of a center meter 12, a headup display device 13, an air conditioning unit 14 including an air conditioning control unit (ECU) 14a and the like and an instrument panel 9 is provided in such a way as to cover the surface, which becomes the inside of the vehicle compartment, of these parts.

Reception connectors 16, 17 that form electric connection terminals to the vehicle side when mounted in the vehicle are held and fixed by the structural member including the bar-shaped member 10 and the bracket 11 in such a way that their connection surfaces are on the back side (front side in the drawing). These reception connectors 16, 17 are held and fixed near a position reference hole (position reference portion) 19 that becomes a position reference on the cockpit module 1 side when the cockpit module 1 is mounted in the vehicle and are connected to the connectors on the vehicle side at the same time when the cockpit module 1 is mounted in the vehicle.

These reception connectors 16, 17 are fixed to one end side of a wire harness 15 extending in the cockpit module 1 and the other end side of this wire harness 15 is connected to mounted parts such as the center meter 12, the headup display device and the air conditioning unit 14.

In the cockpit module 1 of this embodiment, the reception connector 16 is directly fixed to the end portion of the wire harness 15 and the reception connector 17 is fixed to the back side (front side in the drawing) of a junction box 18 to which a plurality of end portions of the wire harness 15 are connected.

The cockpit module 1 of the above construction, as shown in FIG. 1, is assembled on the base of an assembly truck 30 and then is transported to the connection arrangement part 20 of the electric inspection device 2 as it is placed on the assembly truck 30 and an electric inspection of the respective parts (automatic inspection of operating function, and manual operation and visual inspection of operating parts and display parts) is conducted.

As shown in FIG. 1, in the connection arrangement part 20 of the electric inspection device 2, the wire harness 21 extending from the main portion of the inspection device (not shown) is provided at its end portion with an inspection connector 22 to be connected (electrically connected) to the reception connectors 16, 17 of the cockpit module 1.

A base part 23 is provided on the floor below the inspection connector 22 and this base part 23 is provided with a holding part (holding member) 25 via a link mechanism 24. The inspection connector 22 is fixed and held by the holding part 25 in such a way that its surface to be connected to the reception connectors 16, 17 is opposed to the connection surfaces of the reception connectors 16, 17.

A flexible member formed of a resin spring is provided on the outer peripheral surface of connector housing of the inspection connector 22 and the inspection connector 22 is fixed and held by the holding part 25 via this flexible member. With this, the position where the inspection connector 22 is held and fixed by the holding part 25 can be varied slightly according to the amount of deflection of the flexible member. In other words, the inspection connector 22 of this embodiment becomes a connector provided with position correction means when it is fitted in the reception connectors 16, 17.

A swing arm (arm member) 26 extending upward to the right in the drawing is turnably provided on the front side on the sheet (on the left side when viewed from the front side of the cockpit module 1) of the base part 23. The swing arm 26 is coupled to the link mechanism 24 at a turning center point near the end portion on the base part 23 side.

The swing arm 26 extends such that its end on the opposite side of the base part 23 reaches the front side (right side in the drawing) of the cockpit module 1. When the tip of this swing arm 26 is pulled down, the holding part 25 that fixes and holds the inspection connector 22 moves nearly in the horizontal direction from the position shown by a solid line in FIG. 1 to the position shown by a double dot and dash line with the connection surface of the inspection connector 22 being held in a predetermined direction.

On the other hand, when the tip of the swing arm 26 is pulled upward from this state, the holding part 25 that fixes and holds the inspection connector 22 returns from the position shown by a double dot and dash line shown in FIG. 1 to the position shown by the solid line with the connection surface of the inspection connector 22 being held in a predetermined direction. A construction including the link mechanism 24 and the swing arm 26 is moving means in this embodiment.

A pair of guide rails 27 is so provided as to extend along the floor surface from the base part 23. The pair of guide rails controls the side position (front and back sides of paper) of wheels 31 of the assembly truck 30. When the assembly truck 30 having the cockpit module 1 placed at a predetermined assembly position on the base is moved between the pair of guide rails 27 along the rails, the connection surface of the reception connectors 16, 17 of the cockpit module 1 and the connection surface of the inspection connector 22 of the electric inspection device 2 are always kept at opposed positions in the vertical direction and in the lateral direction (in the direction of width of the cockpit module 1 and in the direction of front and back sides of the sheet).

Further, a stopper 28, which protrudes from the floor surface at a position of a predetermined distance from the base part 23 and forms a step, is provided at a portion that becomes the path of the wheel 31 of the assembly truck 30 on the floor surface between the pair of guide rails 27.

When the wheel 31 on the left side in the drawing of the assembly truck 30 climbs over the stopper 28 from the right side in the drawing, the left end in the drawing of the assembly truck 30 is made to abut against the base part 23 nearly at the same time when the wheel 31 finishes climbing over the stopper 28. That is, the base part 23 has a function as a stopper of the assembly truck 30 and the right surface in the drawing of the base part 23 and the left surface in the drawing of the stopper 28 can control the position in the direction in which the assembly truck 30 is moved forward and backward (lateral direction in the drawing) between the guide rails 27 of the assembly truck 30.

A construction including the base part 25, the guide rails 27, and the stopper 28 is position control means in this embodiment.

Next, the operation when the cockpit module 1 is inspected by the electric inspection device 2 of this embodiment will be described on the basis of the above construction.

When the assembling of the cockpit module 1 on the assembly truck 30 is completed, as shown in FIG. 1, the assembly truck 30 is moved to the connection arrangement part 20 of the electric inspection device 20 with the cockpit module 1 placed thereon. At this time, the assembly truck 30 is moved forward between the guide rails 27 of the connection arrangement part 20 by pushing the front side (surface facing inside the vehicle compartment when mounted) of the cockpit module 1 with the back (surface facing inside the vehicle when mounted) of the cockpit module 1 placed on the base being in the forefront.

When the wheel 31 on the forefront side (left side in FIG. 1) of the assembly truck 30 climbs over the stopper 28 and the assembly truck 30 abuts against the base part 23, the assembly truck stops moving forward and the swing arm 26 is pulled down on the front side of the cockpit module 1.

With this, the holding part 25 that fixes and holds the inspection connector 22 is moved forward to the cockpit module 1 by the operating force transmitted via the link mechanism 24. When the holding part 25 that fixes and holds the inspection connector 22 is moved forward to the position shown in FIG. 1 by double dot and dash line, the inspection connector 22 is fitted in the reception connectors 16, 17 of the cockpit module 1 to make connection (electric connection).

When the inspection connector 22 is fitted in the reception connectors 16, 17, the assembly truck 30 having the cockpit module 1 placed thereon is prevented from retracting (moving to the right in the drawing) by the stopper 28. Hence, the reception connectors 16, 17 are prevented from moving back, whereby the connection is made with reliability.

When the inspection of the respective parts is completed, the swing arm 26 is pulled up on the front side of the cockpit module 1. With this, the holding part 25 that fixes and holds the inspection connector 22 is retracted away from the cockpit module 1 in the direction opposite to the direction when the connection is made by the operating force transmitted via the link mechanism 24.

With this, the inspection connector 22 is removed from the reception connectors 16, 17 of the cockpit module 1, whereby the connection (electric connection) is released.

When the inspection connector 22 is removed from the reception connectors 16, 17, the assembly truck 30 having the cockpit module 1 placed thereon is prevented from retracting (moving to the left in the drawing) by the base part 23. Hence, the connection between the inspection connector 22 and the reception connectors 16, 17 is released with reliability.

According to the above-described construction and operation, the inspector can perform the operation of making the connection between the reception connectors 16, 17 and the inspection connector 22 or releasing the connection on the front side of the cockpit module 1 by operating the swing arm 26. Hence, when the inspector makes the connection between the reception connectors 16, 17 and the inspection connector 22 or releases the connection, the inspector does not need to perform the work on the back side of the cockpit module 1. In this manner, this can improve workability in the work of making the connection or releasing the connection.

Further, when the connection is made, the assembly truck 30 having the cockpit module 1 placed thereon is positioned in the direction of width of the module by the guide rails 27, so that the positions of the reception connectors 16, 17 can be made to agree with the position of the inspection connector 22 with high accuracy. Even if there is a small deviation between the positions, the inspection connector 22 is fixed and held by the holding part 25 via the resin spring member and hence this small deviation can be corrected.

Further, when the connection is made, the assembly truck 30 is prevented from retracting by the stopper 28 and when the connection is released, the assembly truck 30 is prevented from moving forward by the base part 23. Hence, the connection between both of the connectors can be made or released with reliability.

Still further, in the electric inspection device 2 in this embodiment, the electric inspection can be conducted as the cockpit module 1 is placed on the assembly truck 30. Hence, the cockpit module 1 is assembled on the assembly truck 30 and then the electric inspection can be conducted without replacing the cockpit module 1, which makes workability in the electric inspection extremely excellent.

Next, the second embodiment will be described on the basis of FIG. 3.

This second embodiment is different from the first embodiment in that the cockpit module 1 is moved to make the connection between the reception connectors 16, 17 and the inspection connector 22 or release the connection. Parts equivalent to those in the first embodiment are denoted by the same reference symbols and their descriptions will be omitted.

As shown in FIG. 3, in the connection arrangement part 120 of the electric inspection device 2 of this embodiment, the base part 23 is provided in a vertically elongated manner and the holding part 25 is provided on the right side in the drawing of this base part 23. The inspection connector 22 is fixed and held by the holding part 25 in such a way that its surface to be connected to the reception connectors 16, 17 is opposed to the connection surfaces of the reception connector 16, 17. The holding part 25 has an impact absorbing member 25a for absorbing impact in the direction in which the connectors are fitted (in the lateral direction in the drawing).

In the connection arrangement part 120 of this embodiment, the pair of guide rails 27 is so provided as to extend along the floor surface from the base part 23 but the stopper 28 is not provided.

When the electric inspection of the cockpit module 1 is conducted by use of the electric inspection device of the above-described construction, as shown in FIG. 3, the assembly truck 30 is moved to the connection arrangement part 120 of the electric inspection device 2 with the cockpit module 1 placed thereon. At this time, the assembly truck 30 is moved forward between the guide rails 27 of the connection arrangement part 120 by pushing the front side (surface facing inside the vehicle compartment when mounted) of the cockpit module 1 with the back (surface facing the vehicle when mounted) of the cockpit module 1 placed on the base being in the forefront.

That is, in this embodiment, the cockpit module 1 is brought nearer to the holding part 25 of the electric inspection device 2.

Since the assembly truck 30 is moved forward between the guide rails 27, while the assembly truck 30 is being moved, the connection surface of the reception connectors 16, 17 and the connection surface of the inspection connector 22 are always kept in an opposed state.

Then, immediately before (or at the same time when) the forefront portion (left end portion in the drawing) of the assembly truck 30 abuts against the base part 23, the reception connectors 16, 17 of the cockpit module 1 reach the position of the inspection connector 22 and the reception connectors 16, 17 of the cockpit module 1 are fitted in the inspection connector 22 to make connection (electric connection). At this time, the fitting of the connectors is performed without causing damage to both of the connectors 16, 17 and the connector 22 by the function of the impact absorbing member 25a.

A construction including the base part 23 and the guide rails 27 is position control means in this embodiment. In this embodiment, the assembly truck 30 is positioned in the direction of travel by the base part 23 nearly at the same time when the connection is made. However, the assembly truck 30 does not need to abut against the base part 23 but the assembly truck 30 may be positioned in the direction of travel by the holding part 25. Hence, the holding part 25 is substantially position control means.

When the inspection connector 22 is connected to the reception connectors 16, 17 of the cockpit module 1 and the electric inspection of the respective parts is completed, the assembly truck 30 is pulled back on the front side of the cockpit module 1 and the assembly truck 30 having the cockpit module 1 placed thereon is moved in the direction opposite to the direction when the connection is made.

With this, the inspection connector 22 is removed from the reception connectors 16, 17 of the cockpit module 1 to release the connection (electric connection).

According to the above-described construction and operation, as is the case with the first embodiment, a work of making the connection between the reception connectors 16, 17 and the inspection connector 22 and of releasing the connection can be performed with ease on the front side of the cockpit module assembly 1. Hence, when the inspector performs the work of making the connection between the reception connectors 16, 17 and the inspection connector 22 and of releasing the connection, the inspector does not need to perform the work on the back side of the cockpit module 1. In this manner, this can improve workability in the making the connection or releasing the connection.

Further, since the inspector does not need to operate the assembly truck 30 so that the wheel 31 of the assembly truck 30 climbs over the stopper, the inspector can easily handle the assembly truck 30 having the cockpit module 1 placed on the base.

In the above-described respective embodiments, the assembly truck 30 is positioned by the position control means such as the base part 23 and the guide rails 27 to control the position in the front and back direction and in the direction of width of the cockpit module 1 placed at the predetermined position of the assembly truck 30, but the position control means is not limited to this. For example, the position control means may control the position of the position reference hole 19 when the cockpit module 1 is mounted in the vehicle. This can directly determine the position of the cockpit module 1 and hence can control the position with high accuracy.

Further, in the above-described respective embodiments, the position reference part is the position reference hole 19 but is not limited to this. For example, the position reference part may be a tapered pin-shaped part which becomes a position reference.

Still further, in the above-described respective embodiments, two reception connectors 16, 17 of the cockpit module 1 are provided but one connector or three or more connectors may be provided.

Still further, in the above-described respective embodiments, the cockpit module 1 is constructed of: the structural member; parts and instrument panels such as meter and air conditioner fixed to the structural member; and the wire harness including the reception connectors, but is not limited to this construction. The invention can be effectively applied to a cockpit module provided with at least the structural member and the wire harness having the reception connector at the end portion.

## Claims

1. An electric inspection device of a cockpit module assembly for a vehicle, the device that conducts an electric inspection of such a cockpit module assembly (1) for a vehicle that is provided with: a structural member (10, 11) for fixing parts (12, 13, 14) mounted in a cockpit of the vehicle; a reception connector (16, 17) held and fixed by the structural member (10, 11) ; and a wire harness (15) that has the reception connector (16, 17) provided at its one end and is connectable to the parts (12, 13, 14) at its other end, the reception connector (16, 17) being arranged on the back, the electric inspection being conducted via the reception connector (16, 17),
wherein the device comprises
an inspection connector (22) that is connectable to the reception connector (16, 17), **characterized in that**
a holding member (25) that holds and fixes the inspection connector (22) in such a way that a connection surface of the inspection connector (22) is opposed to a connection surface of the reception connector (16, 17); and
moving means (24, 26) that moves the holding member (25) to the cockpit module assembly (1) for a vehicle, and
wherein the device moves the holding member (25) to the cockpit module assembly (1) for a vehicle by the moving means (24, 26) to connect the reception connector (16, 17) to the inspection connector (22), and conducts the electric inspection,
wherein the moving means (24, 26) is capable of moving the holding member (25) between the reception connector (16, 17) and the inspection connector (22) in an opposite direction to a direction when connection is made,
wherein the holding member (25) is moved by the moving means (24, 26) in the opposite direction to release the connection between the reception connector (16, 17) and the inspection connector (22),
wherein the moving means (24, 26) includes an arm member (26) extending to a front side of the cockpit module assembly (1) for a vehicle, and
wherein the holding member (25) is moved in association with an operation of the arm member (26).

2. An electric inspection device of a cockpit module assembly for a vehicle, the device that conducts an electric inspection of such a cockpit module assembly (1) for a vehicle that isprovidedwith: a structural member (10, 11) for fixing parts (12, 13, 14) mounted in a cockpit of the vehicle; a reception connector (16, 17) held and fixed by the structural member (10, 11) ; and a wire harness (15) that has the reception connector (16, 17) provided at its one end and is connectable to the parts (12, 13, 14) at its other end, the reception connector (16, 17) being arranged on the back, the electric inspection being conducted via the reception connector (16, 17),
wherein the device comprises
an inspection connector (22) that is connectable to the reception connector (16, 17), **characterized in that**
a holding member (25) that holds and fixes the inspection connector (22) in such a way that a connection surface of the inspection connector (22) is opposed to a connection surface of the reception connector (16, 17),
wherein the device moves the cockpit module assembly (1) for a vehicle to the holding member (25) to connect the reception connector (16, 17) to the inspection connector (22), and conducts the electric inspection, and
wherein the cockpit module assembly (1) for a vehicle is moved in an opposite direction to a direction when connection is made between the reception connector (16, 17) and the connector (22) to release the connection between the reception connector (16, 17) and the inspection connector (22).

3. The electric inspection device of a cockpit module assembly for a vehicle as claimed in claim 1 or 2, further comprising position control means (23, 27, 28) for controlling a position of the cockpit module assembly (1) for a vehicle when connection is made between the connector (16, 17) and the connector (22).

4. The electric inspection device of a cockpit module assembly for a vehicle as claimed in claim 3,
wherein the cockpit module assembly (1) for a vehicle is placed at a predetermined position on a truck (30), and
wherein the position control means (23, 27, 28) controls a position of the truck (30).

5. The electric inspection device of a cockpit module assembly for a vehicle as claimed in claim 4,
wherein the position control means (23, 27, 28) controls a position of the truck (30) in a front and back direction and in a direction of width of the cockpit module assembly (1) for a vehicle.

6. The electric inspection device of a cockpit module assembly for a vehicle as claimed in claim 3,
wherein the cockpit module assembly (1) for a vehicle includes a position reference part (19) when the assembly is mounted in the vehicle, and
wherein the position control means controls a position of the position reference part (19).

7. The electric inspection device of a cockpit module assembly for a vehicle as claimed in claim 6, wherein the cockpit module assembly (1) for a vehicle is placed on a truck (30).

8. The electric inspection device of a cockpit module assembly for a vehicle as claimed in any one of claims 4, 5, and 7, wherein the truck (30) is an assembly truck (30) for assembling the cockpit module assembly (1) for a vehicle on a base.

9. The electric inspection device of a cockpit module assembly for a vehicle as claimed in any one of claims 1 to 8, wherein the inspection connector (22) is held and fixed by the holding member (25) via a flexible member, and a position where the inspection connector (22) is held and fixed by the holding member (25) is varied according to the amount of deflection of the flexible member.

## Patentansprüche

1. Eine elektrische Inspektionsvorrichtung eines Armaturenbrettmodulzusammenbaus für ein Fahrzeug, welche Vorrichtung eine elektrische Inspektion eines derartigen Armaturenbrettmodulzusammenbaus (1) für ein Fahrzeug durchführt, wobei der Zusammenbau mit folgenden Mitteln versehen ist:
ein Bauteil (10, 11) um Teile (12, 13, 14), die in einem Armaturenbrett des Fahrzeugs montiert sind zu befestigen;
ein Empfangsverbinder (16, 17) der von dem Bauteil (10, 11) gehalten und fixiert ist; und
einen Kabelbaum (15), an dessen einem Ende der Empfangsverbinder (16, 17) vorgesehen ist und der an seinem anderen Ende mit den Teilen (12, 13, 14) verbindbar ist, welcher Empfangsverbinder (16, 17) an der Rückseite angeordnet ist, wobei die elektrische Inspektion über den Empfangsverbinder (16, 17) durchgeführt wird, und wobei die Vorrichtung umfasst:
einen Inspektionsverbinder (22), der mit dem Empfangsverbinder (16, 17) verbindbar ist, **gekennzeichnet durch**
ein Haltebauteil (25), welches den Inspektionsverbinder (22) derartig hält und fixiert, dass eine Verbindungsoberfläche des Inspektionsverbinders (22) entgegen einer Verbindungsoberfläche des Empfangsverbinders (16, 17) angeordnet ist; und
Bewegungsmittel (24, 26), welche das Haltebauteil (25) zu dem Armaturenbrettmodulzusammenbau (1) für ein Fahrzeug bewegen, und wobei
die Vorrichtung das Haltebauteil (25) zu dem Armaturenbrettmodulzusammenbau (1) für ein Fahrzeug mittels der Bewegungsmittel (24, 26) bewegt, um den Empfangsverbinder (16, 17) mit dem Inspektionsverbinder (22) zu verbinden und die elektrische Inspektion durchzuführen,
wobei das Bewegungsmittel (24, 26) in der Lage ist das Haltebauteil (25) zwischen dem Empfangsverbinder (16, 17) und dem Inspektionsverbinder (22) in einer entgegen gesetzten Richtung zu einer Richtung zu bewegen, wenn eine Verbindung hergestellt ist,
wobei das Haltebauteil (25) **durch** das Bewegungsmittel (24, 26) in der entgegen gesetzten Richtung bewegt wird, um die Verbindung zwischen dem Empfangsverbinder (16, 17) und dem Inspektionsverbinder (22) zu lösen,
wobei das Bewegungsmittel (24, 26) ein Armbauteil (26) umfasst, dass sich zu einer vorderen Seite des Armaturenbrettmodulzusammenbaus (1) für ein Fahrzeug erstreckt, und
wobei das Haltebauteil (25) in Zusammenhang mit einem Betrieb des Armbauteils (26) bewegt wird.

2. Eine elektrische Inspektionsvorrichtung eines Armaturenbrettmodulzusammenbaus für ein Fahrzeug, welche Vorrichtung eine elektrische Inspektion eines derartigen Armaturenbrettmodulzusammenbaus (1) für ein Fahrzeug durchführt, wobei der Zusammenbau mit folgenden Mitteln versehen ist:
ein Bauteil (10, 11) um Teile (12, 13, 14), die in einem Armaturenbrett des Fahrzeugs montiert sind zu befestigen;
ein Empfangsverbinder (16, 17) der von dem Bauteil (10, 11) gehalten und fixiert ist; und
einen Kabelbaum (15), an dessen einem Ende der Empfangsverbinder (16, 17) vorgesehen ist und der an seinem anderen Ende mit den Teilen (12, 13, 14) verbindbar ist, welcher Empfangsverbinder (16, 17) an der Rückseite angeordnet ist, wobei die elektrische Inspektion über den Empfangsverbinder (16, 17) durchgeführt wird, und wobei die Vorrichtung umfasst:
einen Inspektionsverbinder (22), der mit dem Empfangsverbinder (16, 17) verbindbar ist, **gekennzeichnet durch**
ein Haltebauteil (25), welches den Inspektionsverbinder (22) derart hält und fixiert, dass eine Verbindungsoberfläche des Inspektionsverbinders (22) entgegen zu einer Verbindungsoberfläche des Empfangsverbinders (16, 17) angeordnet ist,
wobei die Vorrichtung den Armaturenbrettmodulzusammenbau (1) für ein Fahrzeug zu dem Haltebauteil (25) bewegt, um den Empfangsverbinder (16, 17) mit dem Inspektionsverbinder (22) zu verbinden, und die elektrische Inspektion durchzuführen, und
wobei der Armaturenbrettmodulzusammenbau (1) für ein Fahrzeug in einer entgegen gesetzten Richtung zu einer Richtung bewegt wird, wenn eine Verbindung zwischen dem Empfangsverbinder (16, 17) und dem Verbinder (22) hergestellt wird, um die Verbindung zwischen dem Empfangsverbinder (16, 17) und dem Inspektionsverbinder (22) zu lösen.

3. Die elektrische Inspektionsvorrichtung eines Armaturenbrettmodulzusammenbaus für ein Fahrzeug nach einem der Ansprüche 1 oder 2, weiter umfassend Positionssteuerungsmittel (23, 27, 28) zur Steuerung einer Position des Armaturenbrettmodulzusammenbaus (1) für ein Fahrzeug, wenn eine Verbindung zwischen dem Verbinder (16, 17) und dem Verbinder (22) hergestellt ist.

4. Die elektrische Inspektionsvorrichtung eines Armaturenbrettmodulzusammenbaus für ein Fahrzeug nach Anspruch 3,
wobei der Armaturenbrettmodulzusammenbau (1) für ein Fahrzeug in einer vorherbestimmten Position auf einem Wagen (30) platziert ist, und wobei die Positionsteuerungsmittel (23, 27, 28) eine Position des Wagens (30) steuern.

5. Die elektrische Inspektionsvorrichtung eines Armaturenbrettmodulzusammenbaus für ein Fahrzeug nach Anspruch 4,
wobei die Positionssteuerungsmittel (23, 27, 28) eine Position des Wagens (30) in einer Vorwärts- und Rückwärtsrichtung und in einer Richtung der Breite des Armaturenbrettmodulzusammenbaus (1) für ein Fahrzeug steuern.

6. Die elektrische Inspektionsvorrichtung für ein Armaturenbrettmodulzusammenbau für ein Fahrzeug nach Anspruch 3, wobei der Armaturenbrettmodulzusammenbau (1) für ein Fahrzeug ein Positionsreferenzteil (19) umfasst, wenn der Zusammenbau in dem Fahrzeug montiert ist, und
wobei das Positionssteuerungsmittel eine Position des Positionsreferenzteils (19) steuert.

7. Die elektrische Inspektionsvorrichtung eines Armaturenbrettmodulzusammenbaus für ein Fahrzeug nach Anspruch 6, wobei der Armaturenbrettmodulzusammenbau (1) für ein Fahrzeug auf einem Wagen (30) platziert ist.

8. Die elektrische Inspektionsvorrichtung eines Armaturenbrettmodulzusammenbaus für ein Fahrzeug nach einem der Ansprüche 4, 5 und 7, wobei der Wagen (30) ein Montagewagen (30) ist, um den Armaturenbrettmodulzusammenbau (1) für ein Fahrzeug auf einem Basiselement zusammenzubauen.

9. Die elektrische Inspektionsvorrichtung eines Armaturenbrettmodulzusammenbaus für ein Fahrzeug nach einem der Ansprüche 1 bis 8, wobei der Inspektionsverbinder (22) durch die Haltemittel (25) über ein flexibles Bauteil gehalten und fixiert wird, und wobei eine Position, in der der Inspektionsverbinder (22) gehalten und fixiert ist, durch das Haltebauteil (25) gemäß der Menge der Abweichung des flexiblen Bauteils variiert wird.

## Revendications

1. Dispositif d'inspection électrique d'un module d'habitacle destiné à un véhicule, le dispositif qui effectue une inspection électrique d'un tel module d'habitacle (1) destiné à un véhicule est muni : d'un organe structurel (10, 11) permettant de fixer des parties (12, 13, 14) montées dans l'habitacle du véhicule ; un connecteur de réception (16, 17) supporté et fixé par l'organe structurel (10, 11) ; et un faisceau électrique (15) qui présente le connecteur de réception (16, 17) prévu à sa première extrémité et peut être connecté aux parties (12, 13, 14) à son autre extrémité, le connecteur de réception (16, 17) étant disposé sur l'arrière, l'inspection électrique étant effectuée par l'intermédiaire du connecteur de réception (16, 17), dans lequel le dispositif comprend
un connecteur d'inspection (22) qui peut être connecté au connecteur de réception (16, 17), **caractérisé par** :
un organe de support (25) qui supporte et fixe le connecteur d'inspection (22) de telle manière qu'une surface de connexion du connecteur d'inspection (22) soit opposé à une surface de connexion du connecteur de réception (16, 17); et
des moyens de déplacement (24, 26) qui déplacent l'organe de support (25) vers le module d'habitacle (1) destiné à un véhicule, et
dans lequel le dispositif déplace l'organe de support (25) vers le module d'habitacle (1) destiné à un véhicule grâce aux moyens de déplacement (24, 26) afin de connecter le connecteur de réception (16, 17) au connecteur d'inspection (22), et effectue l'inspection électrique,
dans lequel les moyens de déplacement (24, 26) sont capables de déplacer l'organe de support (25) entre le connecteur de réception (16, 17) et le connecteur d'inspection (22) dans une direction opposée à une direction lorsque la connexion est réalisée,
dans lequel l'organe de support (25) est déplacé par les moyens de déplacement (24, 26) dans la direction opposée afin de libérer la connexion entre le connecteur de réception (16, 17) et le connecteur d'inspection (22),
dans lequel les moyens de déplacement (24, 26) comprennent un organe de type bras (26) se prolongeant vers un côté avant du module d'habitacle (1) destiné à un véhicule, et
dans lequel l'organe de support (25) est déplacé en association avec un fonctionnement de l'organe de type bras (26).

2. Dispositif d'inspection électrique d'un module d'habitacle destiné à un véhicule, le dispositif qui effectue une inspection électrique d'un tel module d'habitacle (1) destiné à un véhicule qui est muni : d'un organe structurel (10, 11) permettant de fixer des parties (12, 13, 14) montées dans l'habitacle du véhicule ; un connecteur de réception (16, 17) supporté et fixé par l'organe structurel (10, 11); et un faisceau électrique (15) qui présente le connecteur de réception (16, 17) prévu à sa première extrémité et peut être connecté aux parties (12, 13, 14) à son autre extrémité, le connecteur de réception (16, 17) étant disposé sur l'arrière, l'inspection électrique étant effectuée par l'intermédiaire du connecteur de réception (16, 17), dans lequel le dispositif comprend un connecteur d'inspection (22) qui peut être connecté au connecteur de réception (16, 17), **caractérisé par** :
un organe de support (25) qui supporte et fixe le connecteur d'inspection (22) de telle manière qu'une surface de connexion du connecteur d'inspection (22) soit opposée à une surface de connexion du connecteur de réception (16, 17),
dans lequel le dispositif déplace le module d'habitacle (1) destiné à un véhicule vers l'organe de support (25) afin de connecter le connecteur de réception (16, 17) au connecteur d'inspection (22), et effectue l'inspection électrique, et
dans lequel le module d'habitacle (1) destiné à un véhicule est déplacé dans une direction opposée à une direction lorsque la connexion est réalisée entre le connecteur de réception (16, 17) et le connecteur (22) afin de libérer la connexion entre le connecteur de réception (16, 17) et le connecteur d'inspection (22).

3. Dispositif d'inspection électrique d'un module d'habitacle destiné à un véhicule selon la revendication 1 ou 2, comprenant de plus des moyens de réglage de position (23, 27, 28) permettant de régler une position du module d'habitacle (1) destiné à un véhicule quand la connexion est réalisée entre le connecteur (16, 17) et le connecteur (22).

4. Dispositif d'inspection électrique d'un module d'habitacle destiné à un véhicule selon la revendication 3,
dans lequel le module d'habitacle (1) destiné à un véhicule est placé à une position prédéterminée sur un chariot (30), et
dans lequel les moyens de réglage de position (23, 27, 28) règlent une position du chariot (30).

5. Dispositif d'inspection électrique d'un module d'habitacle destiné à un véhicule selon la revendication 4, dans lequel les moyens de réglage de position (23, 27, 28) règlent une position du chariot (30) dans une direction avant et arrière et dans une direction selon la largeur du module d'habitacle (1) destiné à un véhicule.

6. Dispositif d'inspection électrique d'un module d'habitacle destiné à un véhicule selon la revendication 3,
dans lequel le module d'habitacle (1) destiné à un véhicule inclut une partie de référence de position (19) quand le module est monté dans le véhicule, et
dans lequel les moyens de réglage de position règlent une position de la partie de référence de position (19).

7. Dispositif d'inspection électrique d'un module d'habitacle destiné à un véhicule selon la revendication 6, dans lequel le module d'habitacle (1) destiné à un véhicule est placé sur un chariot (30).

8. Dispositif d'inspection électrique d'un module d'habitacle destiné à un véhicule selon l'une quelconque des revendications 4, 5 et 7, dans lequel le chariot (30) est un chariot de montage (30) permettant de monter sur une base le module d'habitacle (1) destiné à un véhicule.

9. Dispositif d'inspection électrique d'un module d'habitacle destiné à un véhicule selon l'une quelconque des revendications 1 à 8, dans lequel le connecteur d'inspection (22) est supporté et fixé par l'organe de support (25) par l'intermédiaire d'un organe souple, et une position où le connecteur d'inspection (22) est supporté et fixé par l'organe de support (25) varie en fonction de la valeur de déviation de l'organe souple.
